# EUROPÄISCHE PATENTANMELDUNG

(11) **EP 0 621 633 A2**
(43) Veröffentlichungstag der Anmeldung: **26.10.1994**
(21) Anmeldenummer: 94102463.0
(22) Anmeldetag: 18.02.1994
(51) Int. Cl.: H01L 23/495

(54) **Leiterrahmen für integrierte Schaltungen**

(30) Priorität: 10.04.1993 DE 4311872
(71) Anmelder: W.C. Heraeus GmbH, D-63450 Hanau (DE)
(72) Erfinder: Herklotz, Günter, Dr., D-63486 Bruchköbel (DE); Förderer, Heinz, D-63538 Grosskrotzenburg (DE); Frey, Thomas, D-63454 Hanau (DE)
(74) Vertreter: Kühn, Hans-Christian

(57) **Zusammenfassung**

Vollständig mit Palladium plattierte Leiterrahmen, die zwischen dem zum Beispiel aus Kupfer bestehenden Grundkörper eine Nickel-Phosphor- oder eine Kupfer-Zinn-Legierungsschicht aufweisen, sind gut bondbar und sowohl vor als auch nach Alterung ohne vorheriges Verzinnen gut lötbar.

## Beschreibung

Die Erfindung betrifft einen Leiterrahmen (lead frame) für integrierte Schaltungen aus einem metallischen Grundkörper und einem aus mindestens zwei Schichten gebildeten Überzug, dessen äußere Schicht aus Palladium besteht.

Die der Herstellung von Halbleiterbauelementen dienenden metallischen Leiterrahmen besitzen eine Anzahl von über später zu entfernende Stege miteinander verbundenen Leiterbahnen und einen Träger (Insel) zum Befestigen des Halbleiterchips. Der Halbleiterchip wird mit Hilfe sehr feiner elektrisch leitender Drähte - sogenannter Bonddrähte - an die dem Träger benachbarten inneren Enden der Leiterbahnen angeschlossen; die äußeren Enden der Leiterbahnen bilden die Anschlußelemente zum Verbinden des Halbleiterbauelements mit anderen elektrischen oder elektronischen Komponenten. Die inneren Anschlüsse werden durch Bonden, zum Beispiel mit Hilfe des Thermosonic-Verfahrens, die äußeren Anschlüsse im allgemeinen durch Löten hergestellt.

Die Leiterrahmen bestehen bevorzugt aus gut wärmeleitenden Metallen und Metall-Legierungen, wie Kupfer und Kupfer-Legierungen, und einer Edelmetall-Plattierung, die entweder selektiv nur den Träger und die für die Anschlüsse vorgesehenen Bereiche des Leiterrahmens oder den Leiterrahmen vollständig bedeckt.

Die Erfindung geht von einem Leiterrahmen aus, wie er beispielsweise aus EP-A-0 132 596, EP-A-0 250 146 und EP-A-0 335 608 bekannt ist.

EP-A-0 132 596 betrifft einen Leiterrahmen für integrierte Schaltungen aus einem aus einer Eisen-Nickel-Legierung bestehenden Grundkörper, dessen Oberfläche mit einer dünnen Nickel-Schicht überzogen ist, die eine sehr dünne Schicht aus Gold, Silber, Palladium oder einer Legierung dieser Metalle trägt. Bedingt durch die ihn bildende Materialkombination, besitzt der Leiterrahmen neben den anderen erforderlichen Eigenschaften auch eine gute Lötbarkeit, so daß aufwendiges selektives Plattieren nicht erforderlich ist.

In EP-A-0 250 146 wird ein allseitig mit Palladium oder einer Palladium-Nickel-Legierung (Nickel-Gehalt 20 %) beschichteter Leiterrahmen beschrieben. Zwischen dem metallischen Grundkörper aus einer Eisen-Nickel-Legierung mit etwa 42 % Nickel, einer Kupfer-Legierung, rostfreiem Stahl oder mit Kupfer ummanteltem Stahl und der Palladium- beziehungsweise Palladium-Nickel-Schicht befindet sich eine Zwischenschicht aus Nickel. Durch die Nickel-Schicht wird die Haftung zwischen dem Grundkörper und der Palladium- beziehungsweise Palladium-Nickel-Schicht verbessert.

Aus EP-A-0 335 608 ist ein Leiterrahmen bekannt, dessen Grundkörper aus Kupfer oder einer Kupfer-Legierung bestehen kann und einen mehrschichtigen Überzug trägt. Zwischen der äußeren aus Palladium gebildeten Schicht und dem Grundkörper befindet sich eine dem Grundkörper benachbarte isolierende Schicht aus zum Beispiel Palladium oder Palladium-Nickel und eine Schicht aus zum Beispiel Nickel. Eine weitere Nickel-Schicht kann zwischen dem Grundkörper und der isolierenden Schicht angeordnet sein.

JP 61-140 160 A bezieht sich auf einen Leiterrahmen für die Herstellung von dicht in Kunststoff eingekapselten und daher langlebigen Halbleiterbauelementen (ICs), und stellt eine Verbesserung der bis dahin bekannten Leiterrahmen dar, die ein feuchtigkeitsundurchlässiges Einkapseln nicht zulassen. Um das gewünschte Ziel zu erreichen, ist der metallische Grundkörper des Leiterrahmens allseitig mit einem Überzug aus Bor, Phosphor, Eisen und/oder Kobalt enthaltenden Nickel-Legierung und einer den Überzug partiell bedeckenden Palladium-Schicht versehen. Dabei bedeckt die partielle Palladium-Schicht den für die Aufnahme des Chips bestimmten Träger und die zur Herstellung der Innenanschlüsse des Chips bestimmten inneren Leiterbahnenden. Die für das nach außen dichte Einkapseln mit Kunststoff wesentlichen Bereiche und die für die Herstellung der Außenanschlüsse bestimmten Bereiche des Leiterrahmens bleiben ohne Palladium-Überzug; ihre Oberfläche wird von der Nickel-Legierung gebildet.

Der Erfindung liegt das Problem zugrunde, einen Leiterrahmen zu finden, der einen metallischen Grundkörper und eine Palladium-Schicht aufweist und neben einer guten Bondbarkeit eine gute Lötbarkeit vor und insbesondere nach einer Alterung besitzt. Ein selektives Plattieren des Chip-Trägers und der inneren und äußeren Enden der Leiterbahnen soll nicht erforderlich sein.

Die Lösung des Problems stellt ein Leiterrahmen dar, der gemäß der Erfindung dadurch gekennzeichnet ist, daß unterhalb der Palladium-Schicht eine Schicht aus einer Nickel-Phosphor-Legierung angeordnet ist.

Erfindungsgemäß wird das Problem ebenfalls durch einen Leiterrahmen gelöst, der dadurch gekennzeichnet ist, daß unterhalb der Palladium-Schicht eine Schicht aus einer Kupfer-Zinn-Legierung angeordnet ist.

Der Phosphor-Gehalt der Nickel-Phosphor-Legierung beträgt 1 - 30 Gewichts-% und der Zinn-Gehalt der Kupfer-Zinn-Legierung 5 - 60 Gewichts-%. Bevorzugt wird jedoch eine Nickel-Phosphor-Legierung mit einem Phosphor-Gehalt von 5 - 10 Gewichts-% und eine Kupfer-Zinn-Legierung mit einem Zinn-Gehalt von 10 - 30 Gewichts-%.

Schichten aus Nickel-Phosphor-Legierungen mit einem Phosphor-Gehalt von 1 - 30 Gewichts-% lassen sich in sehr guter Qualität auf galvanischem Wege erzeugen und bewirken eine gute Lötbarkeit der äußeren Leiterbahnenden. Eine Verringerung beziehungsweise Erhöhung des Phosphor-Gehaltes führt zu einer weniger guten Lötbarkeit, vor allem nach Alterung. Nickel-Phosphor-Legierungen mit einem Phosphor-Gehalt von 5 - 10 Gewichts-% bewirken eine sehr gute Lötbarkeit sowohl vor als auch nach Alterung.

Schichten aus Kupfer-Zinn-Legierungen mit einem Zinn-Gehalt von 5 - 60 Gewichts-% lassen sich in sehr guter Qualität auf galvanischem Wege erzeugen und bewirken eine gute Lötbarkeit der äußeren Leiterbahnenden. Eine Verringerung beziehungsweise eine Erhöhung des Zinn-Gehaltes führt zu einer weniger guten Lötbarkeit, vor allem nach Alterung. Kupfer-Zinn-Legierungen mit einem Zinn-Gehalt von 10 - 30 Gewichts-% bewirken eine sehr gute Lötbarkeit sowohl vor als auch nach Alterung.

Die Dicke der Nickel-Phosphor-Legierungschicht beträgt 0,01 - 5 Mikrometer, vorzugsweise 0,2 - 2 Mikrometer, die der Kupfer-Zinn-Legierungschicht 0,01 - 5 Mikrometer, vorzugsweise 0,2 - 2 Mikrometer und die der Palladium-Schicht 0,01 - 0,5 Mikrometer, vorzugsweise 0,1 Mikrometer.

Besonders bewährt hat es sich, wenn zwischen dem Grundkörper und der Nickel-Phosphor-Legierungsschicht beziehungsweise der Kupfer-Zinn-Legierungschicht eine Nickel-Schicht angeordnet ist. Diese Nickel-Schicht sollte nicht dicker als 5 Mikrometer sein; bevorzugt wird eine 1 - 2 Mikrometer dicke Nickel-Schicht.

Der Grundkörper kann aus jedem dafür geeigneten metallischen Material bestehen; bevorzugt werden jedoch Kupfer und Kupfer-Legierungen.

Der Leiterrahmen gemäß der Erfindung zeichnet sich durch eine gute Bondbarkeit und - wie Lötbarkeitsprüfungen zeigen - durch eine sowohl vor als auch nach Alterung gute Lötbarkeit aus. Die trotz Alterung gute Lötbarkeit gewährleistet zuverlässige Lötverbindungen auch nach längerer Lagerung des Leiterrahmens beziehungsweise der damit hergestellten Halbleiterbauelemente, ohne daß ein vorheriges Verzinnen der äußeren Leiterbahnenden erforderlich ist.

Es muß als überraschend angesehen werden, daß durch die Nickel-Phosphor-Legierungsschicht und die Kupfer-Zinn-Legierungsschicht die Lötbarkeit der darüber befindlichen Palladium-Schicht verbessert, die der Palladium-Schicht eigene gute Bondbarkeit jedoch nicht beeinflußt wird.

Die Herstellung des Leiterrahmens erfolgt, wie an sich bekannt und üblich, durch Ausstanzen des metallischen Grundkörpers aus in Form eines 0,1 - 0,3 Millimeter dicken Streifens vorliegendem metallischem Blech und aufeinanderfolgendes Aufbringen der den Überzug bildenden Schichten, zum Beispiel durch galvanisches oder chemisches Abscheiden aus Metallisierungsbädern, wie sie handelsüblich sind.

So wird zum Beispiel aus einem 0,2 Millimeter dicken CuFe2-Streifen ein metallischer Grundkörper ausgestanzt, falls erforderlich in geeigneter Weise vorbehandelt (Entfetten, Aktivieren u.ä.) und zunächst in einem galvanischen Nickel-Phosphor-Legierungsbad mit einer 1,5 Mikrometer dicken Nickel-Phosphor-Legierungsschicht und dann in einem galvanischen Palladium-Bad mit einer 0,1 Mikrometer dicken Palladium-Schicht versehen. Die abgeschiedene Schicht besteht aus einer Legierung aus 90 Gewichts-% Nickel und 10 Gewichts-% Phosphor.

Entsprechend wird ein Leiterrahmen, wie in Anspruch 2 beschrieben, hergestellt; nur wird anstelle des galvanischen Nickel-Phosphor-Legierungsbades ein galvanisches Kupfer-Zinn-Legierungsbad benutzt. Die abgeschiedene Schicht besteht aus einer Legierung aus 90 Gewichts-% Kupfer und 10 Gewichts-% Zinn und besitzt eine Dicke von 2 Mikrometer.

Ist zusätzlich zu der Nickel-Phosphor- beziehungsweise der Kupfer-Zinn-Legierungsschicht noch eine Nickel-Schicht vorgesehen, so läßt sich diese beispielsweise aus einem galvanischen Nickelsulfamat-Bad abscheiden. Bewährt hat sich eine 1,5 Mikrometer dicke Nickel-Schicht; für die Nickel-Phosphor- beziehungsweise Kupfer-Zinn-Legierungsschicht reicht dann eine Dicke von 0,5 Mikrometer aus.

Die Lötbarkeitsprüfungen erfolgen nach DIN 32 506 durch Bestimmung des Benetzungsverhaltens von zunächst in ein Flußmittel, dann in ein Lötbad getauchten Proben vor und nach Alterung, die aus einer 16stündigen Wärmebehandlung bei 155°C besteht. Das Flußmittel entspricht dem in DIN 32 506 beschriebenen; für das Lötbad wird das Weichlot Sn60Pb40 benutzt. Die Benetzung der Proben mit dem Lot wird visuell beurteilt. Liegt der Benetzungsgrad bei mehr als 95 %, so wird die Lötbarkeit als gut bezeichnet.

Für die Lötbarkeitsprüfungen, deren Ergebnisse in der Tabelle zusammengefaßt werden, wurden die in den Beispielen 1 bis 4 beschriebenen Leiterrahmen gemäß der Erfindung und - zum Vergleich dazu - der in dem Beispiel 5 beschriebene Leiterrahmen gemäß dem Stand der Technik benutzt.

### Beispiel 1

Grundkörper aus CuFe2
1,5 Mikrometer Ni-P (90:10)
0,1 Mikrometer Pd

### Beispiel 2

Grundkörper aus CuFe2
2,0 Mikrometer Cu-Sn (90:10)
0,1 Mikrometer Pd

### Beispiel 3

Grundkörper aus CuFe2
1,5 Mikrometer Ni
0,5 Mikrometer Ni-P (90:10)
0,1 Mikrometer Pd

### Beispiel 4

Grundkörper aus CuFe2
1,5 Mikrometer Ni
0,5 Mikrometer Cu-Sn (90:10)
0,1 Mikrometer Pd

### Beispiel 5 (Vergleich)

Grundkörper aus CuFe2
1,5 Mikrometer Ni
0,1 Mikrometer Pd

**Tabelle**

| Beispiel | Benetzung [%]/Lötbarkeit | |
|---|---|---|
| | vor Alterung | nach Alterung |
| 1 | 100/gut | 100/gut |
| 2 | 100/gut | 100/gut |
| 3 | 100/gut | 100/gut |
| 4 | 100/gut | 100/gut |
| 5 | 100/gut | ≦80/schlecht |
| (Vergleich) | | |

## Patentansprüche

1. Leiterrahmen für integrierte Schaltungen aus einem metallischen Grundkörper und einem aus mindestens zwei Schichten gebildeten Überzug, dessen äußere Schicht aus Palladium besteht, dadurch gekennzeichnet, daß unterhalb der Palladium-Schicht eine Schicht aus einer Nickel-Phosphor-Legierung mit einem Phosphor-Gehalt von 1 - 30 Gewichts-% angeordnet ist.

2. Leiterrahmen für integrierte Schaltungen aus einem metallischen Grundkörper und einem aus mindestens zwei Schichten gebildeten Überzug, dessen äußere Schicht aus Palladium besteht, dadurch gekennzeichnet, daß unterhalb der Palladium-Schicht eine Schicht aus einer Kupfer-Zinn-Legierung mit einem Zinn-Gehalt von 5 - 60 Gewichts-% angeordnet ist.

3. Leiterrahmen nach Anspruch 1, dadurch gekennzeichnet, daß die Nickel-Phosphor-Legierung einen Phosphor-Gehalt von 5 - 10 Gewichts-% besitzt.

4. Leiterrahmen nach Anspruch 1 oder 3, gekennzeichnet durch eine 0,01 - 5 Mikrometer dicke Schicht aus der Nickel-Phosphor-Legierung.

5. Leiterrahmen nach Anspruch 4, gekennzeichnet durch eine 0,2 - 2 Mikrometer dicke Schicht aus der Nickel-Phosphor-Legierung.

6. Leiterrahmen nach Anspruch 2, dadurch gekennzeichnet, daß die Kupfer- Zinn-Legierung einen Zinn-Gehalt von 10 - 30 Gewichts-% besitzt.

7. Leiterrahmen nach Anspruch 2 oder 6, gekennzeichnet durch eine 0,01 - 5 Mikrometer dicke Schicht aus der Kupfer-Zinn-Legierung.

8. Leiterrahmen nach Anspruch 7, gekennzeichnet durch eine 0,2 - 2 Mikrometer dicke Schicht aus der Kupfer-Zinn-Legierung.

9. Leiterrahmen nach einem der Ansprüche 1 bis 8, dadurch gekennzeichnet, daß unmittelbar auf dem Grundkörper eine Nickel-Schicht angeordnet ist.

10. Leiterrahmen nach Anspruch 9, gekennzeichnet durch eine 1 - 2 Mikrometer dicke Nickel-Schicht.

11. Leiterrahmen nach einem der Ansprüche 1 bis 10, gekennzeichnet durch eine 0,01 - 0,5 Mikrometer dicke Palladium-Schicht.

12. Leiterrahmen nach Anspruch 11, gekennzeichnet durch eine 0,1 Mikrometer dicke Palladium-Schicht.

13. Leiterrahmen nach einem der Ansprüche 1 bis 12, dadurch gekennzeichnet, daß der Grundkörper aus Kupfer oder einer Kupfer-Legierung besteht.
